# EUROPÄISCHE PATENTSCHRIFT

(11) **EP 0 690 581 B1**
(45) Veröffentlichungstag und Bekanntmachung des Hinweises auf die Patenterteilung: **29.08.2001**
(21) Anmeldenummer: 95109956.3
(22) Anmeldetag: 26.06.1995
(51) Int. Cl.: H03L 7/07

(54) **Frequenzüberwachungsschaltung eines Taktgenerators**
Frequency control circuit of a clock generator
Circuit de contrôle de la fréquence d'un générateur d'horloge

(30) Priorität: 01.07.1994 DE 4423215
(43) Veröffentlichungstag der Anmeldung: 03.01.1996
(73) Patentinhaber: SIEMENS AKTIENGESELLSCHAFT, 80333 München (DE)
(72) Erfinder: Lindwurm, Franz, Dipl.-Ing., D-80809 München (DE); Ernst, Wolfram, Dipl.-Ing., D-81375 München (DE)

(56) Entgegenhaltungen:
- EP-A- 0 509 706
- GB-A- 1 531 632
- US-A- 4 598 257
- TELCOM REPORT 9, Nr. 4, 1986, Seiten 263-269, XP002005576 ERNST U.A.: "Neue Taktgeneratoren für EWSD"

## Beschreibung

Die Erfindung betrifft eine Frequenzüberwachungsschaltung eines Taktgenerators.

Vermittlungssysteme beinhalten zentrale Taktgeneratoren mit mikroprozessorgesteuerten Phasenregelkreisen, deren Frequenz durch extern zugeführte Referenztaktsignale synchronisiert wird.

Aus dem Patent-Dokument GB-A-1 531 632 sind beispielsweise Phasenregelkreisanordnungen zur Synchronisierung zweier Frequenzen bekannt.

Ein genannter zentraler Taktgenerator ist bspw. aus dem Artikel "Neue Taktgeneratoren für EWSD" von W. Ernst und H.L. Hartmann in der Zeitschrift "Telcom Report", 9. Jahrgang, Heft 4, Seiten 263-269 bekannt.

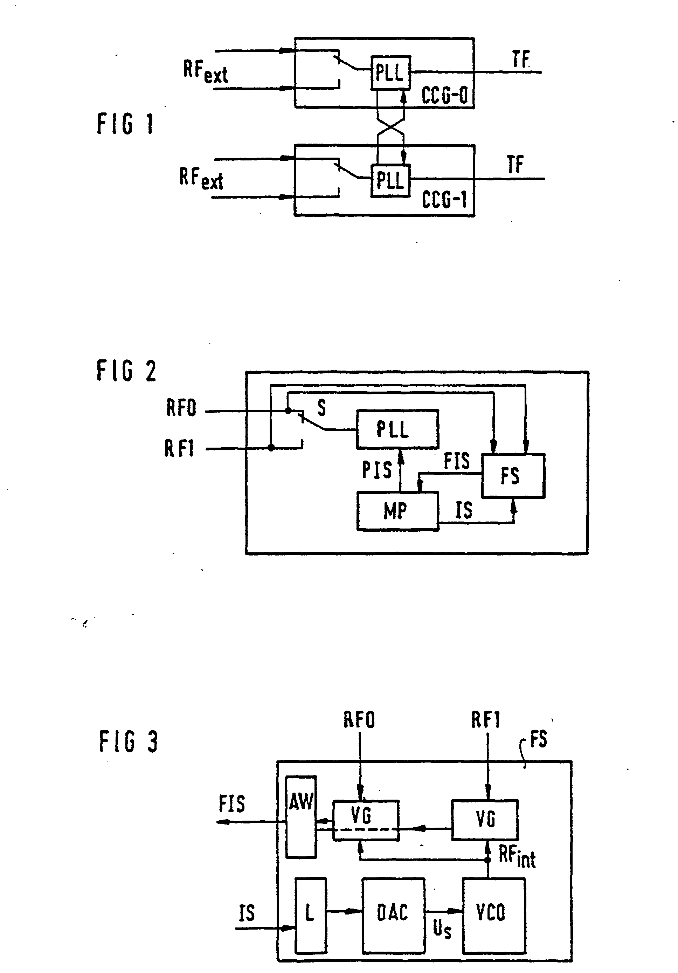

Aus dem genannten Artikel zeigt FIG 1 vereinfacht einen gedoppelten zentralen Taktgenerator, der zwei identische Hälften CCG-0 und CCG-1 mit jeweils einem Phasenregelkreis PLL umfaßt, wobei einer der beiden Phasenregelkreise als aktiver Phasenregelkreis und der andere Phasenregelkreis als inaktiver Phasenregelkreis betrieben wird. An jedem der beiden Phasenregelkreise PLL sind maximal zwei externe Referenztakte RFₑₓₜ anschaltbar, um eine ausfallsichere Synchronisierung zu gewährleisten.

Jeder der beiden Phasenregelkreise PLL umfaßt eine Frequenzüberwachungsschaltung. Diese Schaltung arbeitet prinzipiell in der Weise, daß die externe Referenz mit dem Ausgangssignal des Partner-Phasenregelkreises verglichen wird. Diese Arbeitsweise setzt voraus, daß die Frequenz des Partners eine ausreichende Genauigkeit besitzt, was vorausgesetzt werden kann, wenn beide Phasenregelkreise von voneinander unabhängigen Referenzen gesteuert werden.

In der Praxis werden jedoch in der Regel beide Phasenregelkreise von derselben Referenz (Primär-Referenz) geführt, was zur Folge hat, daß bei Abweichungen der Referenzfrequenz auch der Partner-Phasenregelkreis diesen Abweichungen folgt, wodurch sich das Ausgangssignal des Partner-Phasenregelkreises innerhalb dessen Regelzeitkonstante der externen Referenzfrequenz angleicht. Bei einer gemeinsamen Referenzfrequenz sind die Grenzen des genannten Überwachungsverfahrens deshalb dann erreicht, wenn sich die Regelzeitkonstante des Phasenregelkreises und die Zeit für die Erkennung einer Frequenzabweichung zu nahe kommen. In einem solchen Fall wird der Phasenregelkreis also selbst verstimmt, bevor die Frequenzüberwachung die Abweichung der Referenz erkennen kann.

Ein Taktgenerator der genannten Art kann beispielsweise eine Abweichung, die den Wert 2 x 10 exp(-8) übersteigt, noch sicher erkennen, wenn bei einer angenommenen PI-Regelung die Proportionalzeitkonstante einen Wert von etwa 400sec übersteigt. Bei Abweichungen, die den Wert 2 x 10 exp(-8) unterschreiten, tritt jedoch der genannte Effekt ein, daß die Fehlererkennungszeit aufgrund der kleinen Frequenzabweichung so groß wird, daß sich der Partner-Phasenregelkreis auf diese Frequenz synchronisiert und damit als interne Referenz der Frequenzüberwachungsschaltung nicht mehr geeignet ist.

Der Erfindung liegt die Aufgabe zugrunde, eine Frequenzüberwachungsschaltung anzugeben, die in der Lage ist auch sehr kleine Frequenzabweichungen zu überwachen.

Diese Aufgabe wird durch eine Schaltung gemäß den Merkmalen des Anspruchs 1 gelöst.

Die erfindungsgemäße Lösung ist insbesondere sehr preiswert, da es z.B. zur Lösung der genannten Aufgabe auch möglich wäre, ein teures Rubidiumstandard als interne Referenz zu verwenden. Ein solches Frequenznormal bietet nämlich immer eine Genauigkeit von < 1 x 10 exp (-10) und ist damit um zwei Zehnerpotenzen besser als die zu überwachende Referenzfrequenz.

Im folgenden wird ein Ausführungsbeispiel der Erfindung anhand der FIG 2 und 3 näher erläutert.

FIG 2 zeigt die im Zusammenhang mit der vorliegenden Erfindung wesentlichen Teile einer Hälfte eines Taktgenerators, nämlich einen Phasenregelkreis PLL, einen Mikroprozessor MP als digitalen PI-Regler des Phasenregelkreises PLL und eine Frequenzüberwachungsschaltung FS, der über einen Schalter S wahlweise eine von zwei zu überwachenden externen Referenzfrequenzen RF0 und RF1 zugeführt wird.

Der Mikroprozessor MP realisiert bezüglich des Phasenregelkreises einen PI-Regler, wobei er über das Steuersignal PIS den Phasenregelkreis nachsteuert. Als PI-Regler beinhaltet das Steuersignal des Mikroprozessors auch einen Integrations-Anteil. Dieser Integrations-Anteil des Steuersignals stellt den Langzeit-Mittelwert aus den vorangegangenen Regelvorgängen dar. Dieser Integrations-Anteil wird nun als Steuersignal IS für den Oszillator der Frequenzüberwachungsschaltung herangezogen. Eine Veränderung des Integrations-Anteils durch eine fehlerhafte externe Referenz während der Fehlererkennungszeit in der Frequenzüberwachungsschaltung ist nämlich vernachläßigbar, da die Integrations-Zeitkonstante sehr viel größer als die Proportional-Zeitkonstante des Phasenregelkreises ist, und zwar mindestens um den Faktor 35. Die derartig erzeugte interne Referenzfrequenz bietet damit eine ausreichende Genauigkeit, um Abweichungen < 10 exp(-8) sicher zu erkennen.

Der Mikroprozessor MP steuert somit, abgesehen von dem Oszillator des Phasenregelkreises PLL einen weiteren Oszillator, der zur Frequenzüberwachung gehört. Dieser Oszillator für die interne Referenzfrequenz kann eine geringe Güte aufweisen, da er mit dem jeweils aktuellen Wert des Integrations-Anteils des Steuersignals PIS gesteuert wird und aus diesem die interne Referenzfrequenz gewinnt.

FIG 3 zeigt ein Ausführungsbeispiel einer erfindungsgemäßen Frequenzüberwachungsschaltung FS. Die Frequenzüberwachungsschaltung umfaßt zwei Vergleicher VG, wobei ein Vergleicher jeweils von Null ausgehend die sich über einen vorgegebenen Meßzeitraum einstellende Phasendifferenz zwischen der ihm zugeführten externen Referenzfrequenz und der internen Referenzfrequenz ermittelt.

Die Auswerteschaltung AW ermittelt anhand der von dem momentan aktiven Vergleicher ermittelten Phasendifferenz und anhand des vorgegebenen Meßzeitraums die Frequenzabweichung zwischen der externen Referenzfrequenz und einer internen Referenzfrequenz RFᵢₙₜ und sendet bei Überschreiten einer bestimmten Frequenzabweichung ein Fehlersignal FIS an den Mikroprozessor MP des zentralen Taktgenerators.

Der spannungskontrollierte Oszillator VCO erzeugt die interne Referenzfrequenz RFᵢₙₜ entsprechend einem Spannungssignal U_{S} des Digital-Analog-Wandlers DAC.

Der Digital-Analog-Wandler erzeugt das Analogspannungssignal U_{S} anhand eines von einem Latch L empfangenen digitalen Steuerwortes. Das digitale Steuerungswort entspricht dem Integrations-Signal IS in FIG 2, das im Latch einen Takt zwischengespeichert wird, bevor es an den Digital-Analog-Wandler weitergegeben wird.

Wie bereits erwähnt, wird mittels des Integrations-Signals, das eine relativ große Zeitkonstante aufweist, vom spannungsgesteuerten Oszillator ein stabiles internes Referenzsignal erzeugt, mit welchem die Frequenzstabilität der externen Referenzfrequenzen bestimmt werden kann. Im Falle einer Abweichung von einem Normalwert, wird der Fehler von der Auswerteschaltung AW an den Mikroprozessor gemeldet. Der Mikroprozessor veranlaßt daraufhin eine entsprechende Rekonfiguration des zentralen Taktgenerators, d.h. beispielsweise die Verwendung einer anderen externen Referenzfrequenz zur Regelung oder die Umschaltung des aktiven Phasenregelkreises in den Holdover-Modus, in dem der spannungsgesteuerte Oszillator des Phasenregelkreises mit dem letzten korrekten Stellwert betrieben (gehalten) wird.

## Patentansprüche

1. Frequenzüberwachungsschaltung (FS) eines Taktgenerators, wobei der Taktgenerator einen Phasenregelkreis (PLL) enthält, der anhand einer Referenzfrequenz (RFₑₓₜ) eine Taktfrequenz (TF) erzeugt,
mit
a) einem Vergleicher (VG), der anhand des Vergleichs der externen Referenzfrequenz (RFₑₓₜ) mit einer internen Referenzfrequenz (RFᵢₙₜ) der Frequenzüberwachungsschaltung die sich über einen vorgegebenen Meßzeitraum einstellende Phasendifferenz ermittelt,
b) eine Auswerteschaltung (AW), die anhand der vom Vergleicher ermittelten Phasendifferenz und des bekannten Meßzeitraums die Frequenzabweichung zwischen den beiden Referenzfrequenzen ermittelt und bei Überschreiten einer bestimmten Schwelle ein Fehlersignal an eine übergeordnete Steuerung sendet,
c) einem spannungsgesteuerten Oszillator (VCO), der die genannte interne Referenzfrequenz (RFᵢₙₜ) erzeugt,
**dadurch gekennzeichnet**, daß
d) dem spannungsgesteuerten Oszillator (VCO) als Steuersignal der Integrations-Anteil des Steuersignals des Reglers (MP) des Phasenregelkreises zugeführt wird.

## Claims

1. Frequency monitoring circuit (FS) for a clock generator, with the clock generator containing a phase locked loop (PLL) which uses a reference frequency (RFₑₓₜ) to produce a clock frequency (TF), having
a) a comparator (VG) which compares the external reference frequency (RFₑₓₜ) with an internal reference frequency (RFᵢₙₜ) for the frequency monitoring circuit in order to determine the phase difference that occurs over a predetermined measurement time period,
b) an evaluation circuit (AW) which uses the phase difference determined by the comparator and the known measurement time period to determine the frequency error between the two reference frequencies and, if a specific threshold is exceeded, transmits a fault signal to a higherlevel controller,
c) a voltage controlled oscillator (VCO) which produces the said internal reference frequency (RFᵢₙₜ),
**characterized in that**
d) the integration component of the control signal from the regulator (MP) for the phase locked loop is supplied as control signal to the voltage controlled oscillator (VCO).

## Revendications

1. Circuit (FS) de surveillance de fréquence d'un générateur d'horloge, le générateur d'horloge contenant une boucle (PLL) d'asservissement de phases qui produit à l'aide d'une fréquence (RFₑₓₜ) de référence une fréquence (TF) d'horloge,
comportant
a) un comparateur (VG) qui détermine à l'aide de la comparaison de la fréquence (RFₑₓₜ) de référence externe à une fréquence (RFᵢₙₜ) de référence interne du circuit de surveillance de fréquence la différence de phases s'établissant sur un laps de temps de mesure prescrit,
b) un circuit (AW) d'exploitation, qui détermine à l'aide de la différence de phases déterminée par le comparateur et du laps de temps de mesure connue l'écart de fréquence entre les deux fréquences de référence et, en cas de dépassement d'un seuil déterminé, envoie un signal d'erreur à une commande de rang supérieure,
c) un oscillateur (VCO) commandé en tension qui produit la fréquence (RFᵢₙₜ) de référence interne mentionnée,
**caractérisé en ce que**
d) il est envoyé à l'oscillateur (VCO) commandé en tension, comme signal de commande, la partie d'intégration du signal de commande du régulateur (MP) de la boucle d'asservissement de phases.
